# EUROPEAN PATENT APPLICATION

(11) **EP 4 307 848 A1**
(43) Date of publication of application: **17.01.2024**
(21) Application number: 22185085.2
(22) Date of filing: 15.07.2022
(51) Int. Cl.: H05K 7/20

(54) **ELECTRONIC DEVICE ASSEMBLY**

(71) Applicant: Koninklijke Philips N.V., 5656 AG Eindhoven (NL)
(72) Inventor: WAGNER, Bernd, Eindhoven (NL); SATTEL, Timo Frederik, Eindhoven (NL); RADVAN, Jens, 5656AG Eindhoven (NL); MUETER, Ulf, 5656AG Eindhoven (NL); KAHL, Christoph, Eindhoven (NL)
(74) Representative: Philips Intellectual Property & Standards

(57) **Abstract**

The invention relates to an electronic device assembly and a high voltage generator (advantageously applied in an X-ray device) including the electronic device assembly. The assembly comprises an electronic device (1) having a contact pin (2), and first and second opposing sides (11,12). A printed circuit board (3) has first and second opposing sides (31, 32). The second side (32) of the printed circuit board (3) faces the first side (11) of the electronic device (1). The printed circuit board (3) is connected to the contact pin (2). A heatsink (4) is positioned at the second side (12) of the electronic device (1). A pressure element (5) is configured to apply a pressure between the electronic device (1) and the heat sink (4), by contacting a pressure contact surface (13) on the first side (11) of the electronic device (1). The pressure contact surface (13) of the electronic device (1) is located at the second side (32) of the printed circuit board (3).

## Description

### FIELD OF THE INVENTION

The invention relates to an electronic device assembly, a high voltage generator comprising the electronic device assembly, and an X-ray device comprising the high voltage generator.

### BACKGROUND OF THE INVENTION

Packaging and/or integration of electronic devices on the level of an assembly with e.g. printed circuit boards is a key aspect of designing and manufacturing electronic products and systems. Multiple boundary conditions need to be considered, such as mechanical protection, cooling, radiofrequency noise, electric discharge etc. In particular for high voltage applications that need to comply with safety standards, such as medical device standards, boundary conditions with respect to air clearance and creepage distances may be especially challenging.

The housings of electronic devices, such as power electronic device sometimes have considerable tolerances in their mechanical dimensions, such as in their thickness in the press-on direction. Fixing the devices to the electronic device assembly therefore requires compensating for these tolerances.

Semiconductor packages, electrical resistors capacitors or other electronic components may have a high voltage rating, e.g. 600 V or even 1200 V. Consequently, sufficient air clearances and creepage distances must be maintained between contacts of the package and the related potentials of the printed circuit board. Particularly for high voltage applications that must comply with the medical device standards, such as IEC 60601-1, there are large creepage distances required for the power semiconductors and associated circuits of printed circuit board assemblies.

Power semiconductors or resistors are often packed in packages which enable a power dissipation during operation such that a considerable heat flux must be transferred to a cooling element connected to the said package. For this purpose, a certain part of the surface is sometimes metallic. The metallic part of the surface may be at electric potential and thus requires appropriate electrical insulation with suitable clearance and creepage distances.

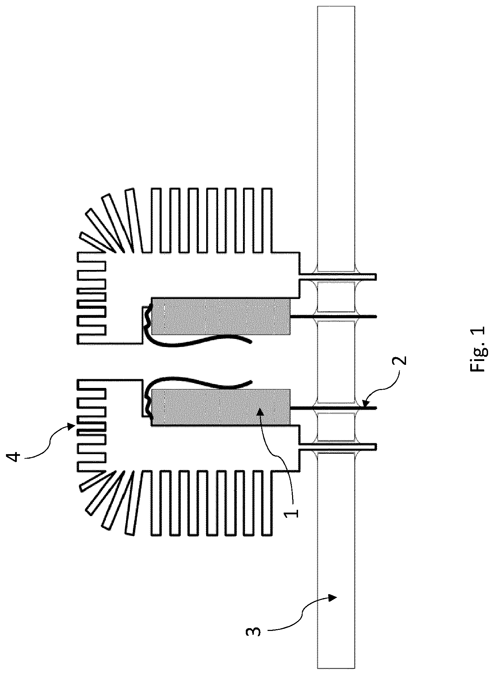

Fig. 1 illustrates an example of an existing assembly with a heatsink 4 clipped on to an electronic device 1, which in turn is connected to a printed circuit board 3 via a pin 2. Such solutions with a mechanical heatsink to cool the electronic device can consume comparatively large areas on the top side of the printed circuit board, particularly when considering sufficient air clearance. Particularly with larger or heavier heatsinks, such an arrangement may be sensitive when exposed to mechanical loads such as shocks or vibrations.

Existing electronic device assemblies may thus suffer from disadvantages, such as risk of incompliance with standards, insufficient cooling, imbalances due to tolerances in device size, large consumption of space on the top side of the printed circuit board, and/or sensitivity to mechanical stress etc.

### SUMMARY OF THE INVENTION

It is therefore an object of the invention to provide an electronic devices assembly with improved mechanical and thermal integration.

The invention is defined by the independent claims. Advantageous embodiments are defined in the dependent claims.

According to a first aspect of the invention, there is provided an electronic device assembly, the assembly comprising:
- an electronic device comprising a contact pin, and first and second opposing sides;
- a printed circuit board having first and second opposing sides, wherein the second side of the printed circuit board faces the first side of the electronic device, and wherein the printed circuit board is connected to the contact pin;
- a heatsink positioned at the second side of the electronic device; and
- a pressure element configured to apply a pressure between the electronic device and the heat sink, by contacting a pressure contact surface on the first side of the electronic device, wherein the pressure contact surface of the electronic device is located at the second side of the printed circuit board.

The proposed assembly may advantageously improve mechanical and thermal integration of the electronic devices on the heatsink. Thermal imbalances and/or insufficient heat dissipation due to tolerances of e.g. electronic device housing thicknesses may be avoided thanks to the arrangement of the pressure element that applies pressure between the device and the heatsink. Furthermore, the arrangement allows for a mechanically stable structure suited to include multiple devices with varying tolerances fixed to a single plane of the heatsink, with sufficient creepage distances between devices. The heatsink in the proposed arrangement provides efficient cooling of the devices as well as mechanical stability. Since no or substantially no pressure is applied with the pressure element on to the printed circuit board, the risk of mechanical damages to the board, e.g. during transport and/or operation, may be reduced.

In an embodiment of the invention, the electronic device is a power electronic device. The invention is particularly advantageous for power electronic devices. Power electronic devices are examples of devices for which boundary conditions around aspects such as creepage distances, tolerance variations and heat dissipation may be especially important. Power electronic devices are devices that process electrical energy, such as but not limited to Silicon Carbide devices, power semiconductors, power transistors, rectifiers, inverters, power resistors, power capacitors etc. Such devices may need to be cooled by transferring heat to one or more rigid heatsinks via the surface of the device. These power electronic devices may comprise multiple electrically conductive contacts (pins) which penetrate the housing wall. Non-limiting examples are power electronic devices with so called TO-220, TO-247, TO-264 housings or so called top-side cooled SMD DDPAK or QDPAK housings.

In an embodiment of the invention, the assembly further comprising a thermally conducting and electrically insulating layer, located between the second side of the electronic device and the heat sink. A thermally conducting and electrically insulating layer can provide electrical insulation between the electronic device and the heat sink, while at the same time allow for good mechanical contact with the device as well as heat conduction from the device to the heat sink. Embodiments of the invention may be particularly suited for simplified assembly with such a layer, since the structure does not require the layer to be cut very precisely and closely to edges of the electronic device.

In an embodiment of the invention, the pressure element comprises a spring or a clip or a washer. Having a pressure element in the form of a (preloaded) spring, clip, washer or similar may be advantageous to correct for variability in electronic device dimensions as well as to regulate and avoid excessive pressure applied between the electronic device and the heatsink.

In an embodiment of the invention, the electronic device comprises a heat conducting surface located at the second side of the electronic device. The assembly as described above, and heat dissipation therein may be particularly advantageous for electronic devices having a heat conducting surface at the side facing the heatsink.

In an embodiment of the invention, the pressure element extends through an opening in the printed circuit board. An embodiment with openings, such as but not limited to, drilled holes or other milled openings in the printed circuit board may be advantageous for simplified assembling of the different layers of the electronic device assembly. In this way pressure elements can be applied from the side of the printed circuit board, through the board via the opening, to contact the electronic device on the other side with no or substantially no pressure applied to the printed circuit board.

According to a second aspect of the invention, there is provided a high voltage generator comprising the electronic device assembly as described in the first aspect of the invention or any of the related embodiments.

The high voltage generator may be an X-ray high voltage generator. An X-ray high voltage generator is a device which supplies electrical power to an X-ray source, e.g. to an X-ray tube for medical imaging with X-ray radiation for diagnostic and/or interventional purposes. As an example, a high voltage generator may comprise a resonator, inverter and/or a transformer to generate a voltage, e.g., a high AC voltage. The generator may include an energy injector, configured to inject energy into the resonator to increase the output voltage.

X-ray high voltage generators are examples of devices with multiple strict boundary conditions for the electronics due to the high voltage, high currents as well as medical device and safety regulations. Therefore, an improved electronic devices assembly, particularly an improved power electronic device assembly, may be particularly advantageous for such an application. Inside an X-ray high voltage generator, the proposed electronic device assembly may advantageously be used in the high voltage inverter but could also be used in other parts, such as but not limited to an anode-drive or other internal switched-mode-power-supplies.

These and other aspects of the invention will be apparent from and elucidated with reference to the embodiments described hereinafter.

### BRIEF DESCRIPTION OF THE DRAWINGS

Fig. 1 schematically illustrates a known electronic device assembly.
Fig. 2 schematically illustrates and electronic device assembly according to an embodiment of the invention.
Fig. 3 schematically illustrates pressure elements according to embodiments of the invention.
Fig. 4 schematically illustrates and electronic device assembly according to an embodiment of the invention.
Fig. 5 schematically illustrates and electronic device assembly according to an embodiment of the invention.
Fig. 6 schematically illustrates and electronic device assembly according to an embodiment of the invention.

### DETAILED DESCRIPTION OF EMBODIMENTS

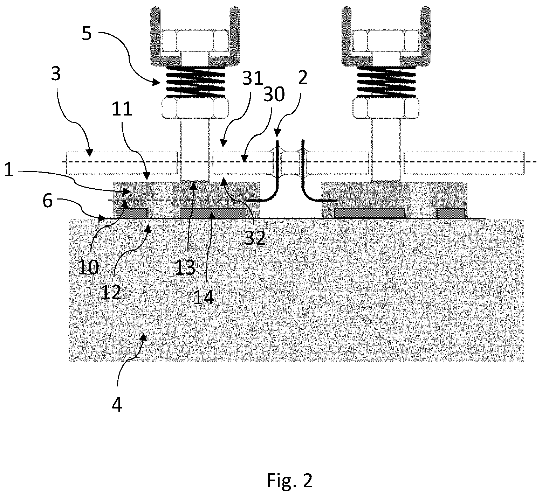

An electronic device assembly according to an embodiment of the invention is illustrated in Fig. 2. As shown in the figure, an electronic device 1 is connected, via one or several contact pins 2, to a printed circuit board 3. The electronic device 1 has first and second opposing sides 11,12 separated by an imaginary plane 10 through the electronic device 1. In the example in the figure, the first side 11 is at the top of the electronic device 1 and the second side 12 is at the bottom. However, it can be appreciated that the arrangement can be rotated in any direction.

The printed circuit board 3 has a first and a second opposing sides 31, 32 separated by an imaginary plane 30 through the printed circuit board 3. The printed circuit board is located at the first side 11 of the electronic device 1, such that the second side 32 of the printed circuit board 3 faces the first side 11 of the electronic device 1. At the other side 12 of the electronic device 1 is the heatsink 4.

As shown in Fig. 2, the electronic device 1 is thus located between the heatsink 4 and the printed circuit board 3. In Fig. 2, a thermally conducting and electrically insulating foil 6 is placed between the electronic device 1 and the rigid heatsink 4 to provide the electrical insulation. The foil 6 should be electrically insulating but thermally conductive such that it can allow heat conduction between the electronic device 1 and the heatsink 4. A non-limiting example of such a layer is a polyimide foil, but other materials with such suitable properties can also be used.

In order to achieve a sufficient heat transfer, the mechanical stack of the electronic device 1, isolation foil 6 and the heatsink 4 may need to fulfill two conditions. Firstly, the surface properties of these parts should preferably allow for a suitable mechanical contact i.e. by means of a good flatness, a low roughness and/or by the absence of cavities that might enclose air after mounting. The foil may therefore not only provide thermal conductivity and electrical insulation but may also improve the mechanical contact by e.g. smoothing out surface roughness of the electronic device 1 and/or heatsink 4. Secondly, a good heat transfer between these items requires a certain minimal contact pressure.

In Fig. 2, a pressure element 5, comprising a preloaded spring and a screw and a nut and a bolt is used to press on a contact surface 13 of the electronic device 1. The electronic device 1 is thereby pressed towards the heatsink 4, such that pressure between the electronic device 1 and the heatsink 4 increases. Thanks to the pressure from the pressure element, heat transfer between the electronic device 1 and the heatsink 4, in this example via the thermally conducting and electrically insulating layer 6, can be improved. In the architecture shown here, the thermally conducting and electrically insulating layer 6 does not have to be cut around the electronic device 1. Thus, assembly of the stack may be simplified. Furthermore, there is no perforation needed in the insulation foil 6 at places closely to electrical potentials, which may help to reduce creepage.

The electronic devices 1 in Fig. 2 may be connected to the printed circuit board 3 in such a way that an on the electronic device 1 metalized or otherwise heat conducting surface 14, which is intended for heat dissipation, can rest positively on the insulating foil 6, and the latter can rest positively on the heat sink 4. The electrical connector pins 2 can, where needed, be bent to penetrate the related vias of the printed circuit board 3. Alternatively, the pins 2 can be mounted to the second side 32 of the printed circuit board 3. Power semiconductors in packages that are designed for cooling against the direction of connection (top-side cooling) can also be integrated in this way.

As seen from Figures 2, 4, 5 and 6, the heatsink 4 is substantially parallel to the imaginary plane 30 of the printed circuit board 3 and to the imaginary plane 10 of the electronic device 1. Substantially parallel means that the parts of the assembly are stacked such that an angle between the surface of the heatsink that is pressed, with the pressure element 5, towards the electronic device 1 (optionally with the insulating foil 6 in between), and the imaginary planes 10, 30 is less than 20 degrees, preferably less than 10 degrees and even more preferably less than 1 degree.

In Fig. 2, the pressure element 5 extends from the first side 31 of the printed circuit board 3, through an opening or hole in the printed circuit board 3 to contact the electronic device 1 at a pressure contact surface 13 of the electronic device 1, located on the second side 32 of the printed circuit board 3. In this case, the pressure element 5, at the top part of the figure, is attached to a rigid structure, such as a traversing structure. Thus, in this example the pressure forces counteract against a mechanical fixation, such as but not limited to a U-shaped profile from metal, plastic or another solid material, which is rigidly connected to the heatsink 4 or to any other mechanical reference point (not shown in the figure). Multiple electronic devices 1 may be arranged across the surface of the heatsink 4 with multiple pressure elements 5 counteracting against a common or multiple mechanical structures. A common thermally conducting and electrically insulating layer 6 may be positioned between multiple electronic devices 1 and the heatsink 4. For example, it may make sense to arrange power transistors to be connected in parallel in a row. This geometric principle can be used, for example, to realize a complete power inverter connected to a printed circuit board 3. Such as the power inverter in a high voltage generator, e.g. a high voltage generator used to drive an X-ray source.

The surface pressure exerted on the electronic device 1 by the pressure element 5 can be adjusted, e.g. by the construction and the material of the spring as well as by changing the spring travel. This can e.g. be changed by the position of the nut which transmits the force from the rigid structure to the screw. Since the springs may be preloaded in this mechanical setup, thickness tolerances of the devices can be completely compensated for by only small variation of the applied surface pressure.

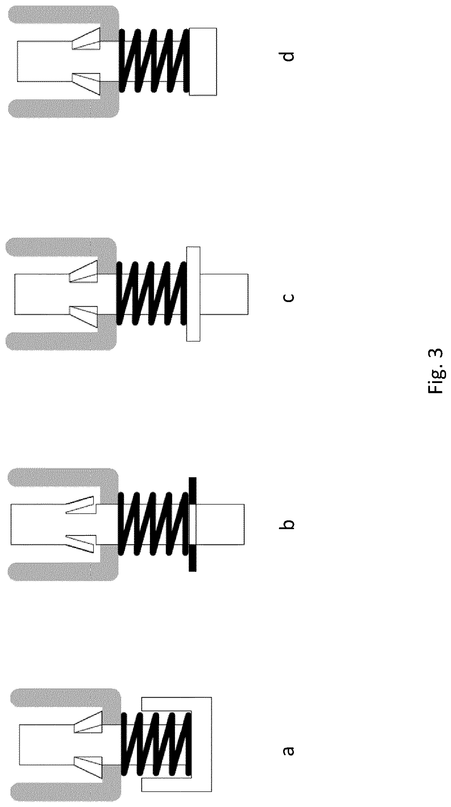

The screw and nut as shown in Fig. 2 may be replaced by other elements to direct a spring force to the electronic device 1, such as but not limited to a bolt, pin, splint and/or punch. A part of the pressure element 5 may be pluggable and/or have lashes or wings to snap-in with the rigid structure. Fig. 3 illustrates non-limiting examples of such pressure elements 5. Fig. 3a shows a pressure element 5 with a spring bolt with a molded base. Such a base may be advantageous to avoid creepage. Fig. 3b illustrates a preloaded spring with forces transmitted via a cotter pin or split. Fig. 3c shows a pressure element 5 where the spring force is transmitted with the help of a molded base of e.g. a plastic bolt. In Fig. 3d, the spring force is transmitted via a punch. Another option, not shown in the figure, is to use a spring and/or other spring-like structure directly in contact with the electronic device, without a screw, pin etc. Since the pressure element 5 in the example in Fig. 2 extends through a hole or opening in the printed circuit board 3, it is possible to put pressure on the electronic device 1 without or with minimal pressure on the printed circuit board 3. Hence, mechanical load on the printed circuit board 3 may be avoided.

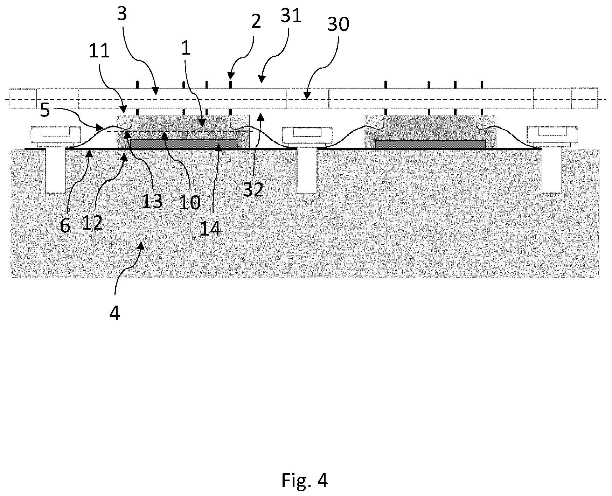

Fig. 4 illustrates an electronic device assembly according to another embodiment. In this case, a solution with retaining clips as the pressure element 5 may be designed in such a way that the clearance and creepage distances between electronic devices 1 are maintained. This variant may be mechanically advantageous because it does not require any constructive structure above (in the figure) the printed circuit board 3 and is therefore more compact. To simplify assembly of the structure, holes or other openings in the printed circuit board 3 can be used to access the screws or other parts of the pressure element 5. Another option is to apply the soldering process after the entire unit is assembled, i.e. when heatsink 4, insulating foil 6, pressure element 5, electronic devices 1 and printed circuit board 3 are in place.

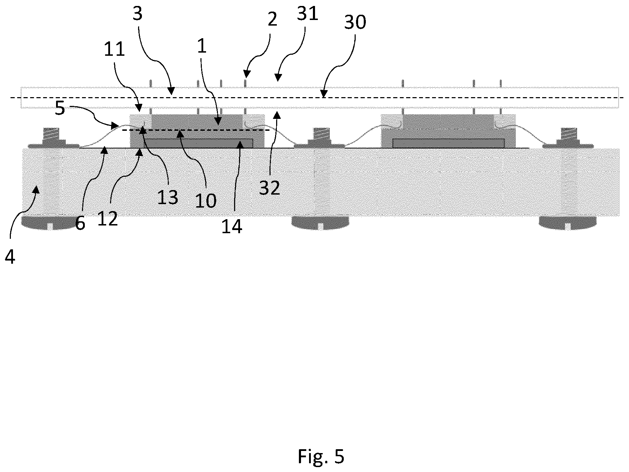

Another example that may help simplify assembly, e.g. when there are no openings in the printed circuit board 3, is illustrated in Fig. 5. In this case, the pressure element 5 is fixated with screws from the 'backside' of the heatsink 4. I.e. from the side that is not facing the electronic device 1. In the structure shown in Fig. 5 the clamps provide a defined pressure for each electronic device 1 and support the different heights due to tolerances of the devices. A variation of this approach might use a much stiffer metal bar instead of the clamps. In such a case the springiness may be introduced e.g. by using a spring washer between screw and heatsink.

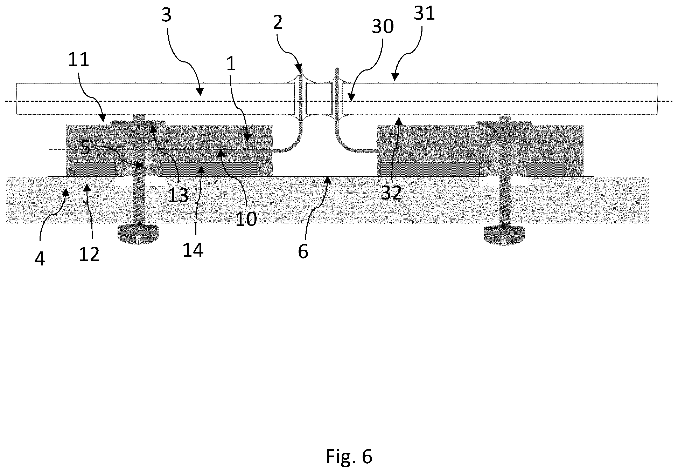

Fig. 6 shows a solution with a screw directly through a mounting hole of the electronic device 1. In case the hole in the device has no thread, a small insert can be used. Preferably, the insert only introduces a minimal additional height and/or inductance. Special attention should also be paid to creepage distances. In the example in Fig 6, a spring washer at the 'bottom' side of the heatsink 4 is used to provide pressure to the electronic device 1.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, several of these means may be embodied by one and the same item of hardware. Measures recited in mutually different dependent claims may advantageously be used in combination.

## Claims

1. Electronic device assembly comprising:
an electronic device (1) comprising a contact pin (2), and first and second opposing sides (11,12);
a printed circuit board (3) having first and second opposing sides (31, 32), wherein the second side (32) of the printed circuit board (3) faces the first side (11) of the electronic device (1), and wherein the printed circuit board (3) is connected to the contact pin (2);
a heatsink (4) positioned at the second side (12) of the electronic device (1); and
a pressure element (5) configured to apply a pressure between the electronic device (1) and the heat sink (4), by contacting a pressure contact surface (13) on the first side (11) of the electronic device (1), wherein the pressure contact surface (13) of the electronic device (1) is located at the second side (32) of the printed circuit board (3).

2. Electronic device assembly according to claim 1, wherein the electronic device (1) is a power electronic device.

3. Electronic device assembly according to claim 1 or 2, the assembly further comprising a thermally conducting and electrically insulating layer (6), located between the second side (12) of the electronic device (1) and the heat sink (4).

4. Electronic device assembly according to any of the preceding claims, wherein the pressure element (5) comprises a spring or a clip or a washer.

5. Electronic device assembly according to any of the preceding claims, wherein the electronic device (1) comprises a heat conducting surface (14) located at the second side (12) of the electronic device (1).

6. Electronic device assembly according to any of the preceding claims, wherein the pressure element extends through an opening in the printed circuit board (3).

7. High voltage generator comprising the electronic device assembly according to any of the preceding claims, wherein the electronic device assembly is preferably used for a high voltage inverter.

8. X-ray device comprising the high voltage generator of claim 7.
